(19)

Europäisches Patentamt
European Patent Office
Office européen des brevets

(11) **EP 4 245 823 A1**

(12) **EUROPEAN PATENT APPLICATION**
published in accordance with Art. 153(4) EPC

(43) Date of publication:
**20.09.2023   Bulletin 2023/38**

(21) Application number: **21891655.9**

(22) Date of filing: **27.10.2021**

(51) International Patent Classification (IPC):
$C09K\ 11/08^{(2006.01)}$     $C09K\ 11/64^{(2006.01)}$
$G03B\ 21/00^{(2006.01)}$     $G03B\ 21/14^{(2006.01)}$
$H01L\ 33/50^{(2010.01)}$     $H01L\ 27/32^{(2006.01)}$
$G02B\ 5/20^{(2006.01)}$      $H05B\ 33/12^{(2006.01)}$
$H01L\ 51/50^{(2006.01)}$

(52) Cooperative Patent Classification (CPC):
**C09K 11/08; C09K 11/64; G02B 5/20; G03B 21/00;
G03B 21/14; H01L 33/50; H05B 33/12;
H10K 50/00; H10K 59/00;** Y02B 20/00

(86) International application number:
**PCT/JP2021/039674**

(87) International publication number:
**WO 2022/102408 (19.05.2022 Gazette 2022/20)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **13.11.2020   JP 2020189675**

(71) Applicant: **SUMITOMO CHEMICAL COMPANY,
LIMITED
Tokyo 103-6020 (JP)**

(72) Inventors:
- **NAITO, Shota
  Tsukuba-shi, Ibaraki 300-3294 (JP)**
- **KANNAMI, Masaki
  Tsukuba-shi, Ibaraki 300-3294 (JP)**
- **IWASAKI, Kentaro
  Niihama-shi, Ehime 792-8521 (JP)**

(74) Representative: **Vossius & Partner
Patentanwälte Rechtsanwälte mbB
Siebertstraße 3
81675 München (DE)**

(54)   **PHOSPHOR**

(57)   A phosphor having an elemental composition represented by the following composition formula: $Sr_yMg_{(1-x)}M_xAl_zO_{(1+y+1.5z)}$ (1), in the formula (1), M represents at least one metal element selected from the group consisting of manganese, cerium, praseodymium, neodymium, samarium, europium, gadolinium, terbium, dysprosium, thulium, and ytterbium, x represents a value of $0.01 \leq x \leq 0.8$, y represents a value of $1 \leq y \leq 2$, and z represents a value of $10 \leq z \leq 22$, wherein the phosphor has a specific surface area of less than 2.7 $m^2$/g.

EP 4 245 823 A1

**Description**

TECHNICAL FIELD

The present invention relates to a phosphor, and particularly to a phosphor used in a light-emitting device.

BACKGROUND ART

As a phosphor used for a white light-emitting diode (LED), Non-Patent Document 1 discloses a phosphor doped with Mn and represented by the composition formula: $Sr_2MgAl_{22}O_{36}$. There is described that the phosphor of Non-Patent Document 1 emits green light having a narrow full width at half maximum and a high color purity when irradiated with a blue LED.

PRIOR ART DOCUMENT

NON-PATENT DOCUMENT

Non-Patent Document 1: Yingli Zhu et al., "NarrowBand Green-Emitting Sr2MgAl22036:Mn2+ Phosphors with Superior Thermal Stability and Wide Color Gamut for Backlighting Display Applications", Adv. Optical Mater., 2019, 7, 1801419, pp. 1-9

SUMMARY OF THE INVENTION

PROBLEMS TO BE SOLVED BY THE INVENTION

Phosphors used in light-emitting devices are required to have characteristics of excellent emission intensity, high emission color purity, and narrow emission peak. In the present specification, the emission peak of the emission spectrum of the phosphor may be simply referred to as "emission peak".

The present invention solves the above problems, and an object of the present invention is to provide a phosphor having enhanced green light emission selectivity, particularly a phosphor of a Mn-doped SrMgAlO compound having enhanced green light emission selectivity.

MEANS FOR SOLVING THE PROBLEMS

The present invention provides a phosphor having an elemental composition represented by the following composition formula:

$$Sr_yMg_{(1-x)}M_xAl_zO_{(1+y+1.5z)}   (1)$$

in the formula (1), M represents at least one metal element selected from the group consisting of manganese, cerium, praseodymium, neodymium, samarium, europium, gadolinium, terbium, dysprosium, thulium, and ytterbium,

   x represents a value of $0.01 \leq x \leq 0.8$,
   y represents a value of $1 \leq y \leq 2$, and
   z represents a value of $10 \leq z \leq 22$,
   wherein the phosphor has a specific surface area of less than 2.7 $m^2/g$.

In an embodiment, in the formula (1), y is 2, and z is 22.
In an embodiment, in the formula (1), M is manganese.
The present invention also provides a film including any one of the above-described phosphors.
The present invention also provides a light-emitting element including any one of the above-described phosphors.
The present invention also provides a light-emitting device including the light-emitting element.
The present invention also provides a display including the light-emitting element.
The present invention also provides a phosphor wheel including any one of the above-described phosphors.
The present invention also provides a projector including the phosphor wheel.
In addition, the present invention provides a method for producing any one of the above-described phosphors, the method including firing a raw material mixture containing a Sr compound as a raw material of a Sr element, a Mg compound as a raw material of a Mg element, an M compound as a raw material of an M element, and an Al compound as a raw material of an Al element.

EFFECT OF THE INVENTION

According to the present invention, it is possible to provide a phosphor having enhanced green light emission selectivity, particularly a phosphor of a Mn-doped SrMgAlO compound having enhanced green light emission selectivity.

MODE FOR CARRYING OUT THE INVENTION

<Phosphor>

The phosphor of the present invention has a crystal of a semiconductor compound represented by the composition formula: $Sr_yMgAl_zO_{(1+y+1.5z)}$ wherein y represents a value of 1 to 2 and z represents a value of 10 to 22, as a host crystal, and has an element M as an activating element. In the formula, y preferably represents 1 or 2, more preferably 2, and z preferably represents 10 or 22, more preferably 22.

The activating element M is a metal element that changes the crystal size by substituting a part of Mg in the semiconductor compound with the activating element M to cause fluorescence emission. Examples of the element M include at least one metal element selected from the group consisting of manganese, cerium, praseodymium, neodymium, samarium, europium, gadolinium, terbium, dysprosium, thulium, and ytterbium. In the phosphor of the present invention, when M is manganese, a divalent manganese ion substantially acts as an emission center ion and emits green light.

When the phosphor is irradiated with excitation light, emission center ions contained in the phosphor absorb the excitation light, and electrons at the ground level transition to the excitation level. When the excited electrons return from the excitation level to the ground level again, energy corresponding to a difference in energy level is emitted as fluorescence. The transition probability of electrons from the ground level to the excitation level varies depending on the electron arrangement of the emission center ions. In the case of forbidden transition with a small transition probability, the absorbance is small and the emission intensity is apparently low. On the other hand, in the case of allowed transition with a large transition probability, the absorbance is large and the emission intensity is apparently high.

Manganese ($Mn^{2+}$) has five electrons in the 3d orbit, and the transition to the excitation level by light irradiation is forbidden transition between the same type of orbits (d-d). Thus, the absorption of light is small and the emission intensity is apparently weak. However, the emission intensity of the phosphor changes depending on the absorbance (number of absorbed photons) of the compound. Therefore, the light emission ability of the phosphor can be objectively evaluated by using the emission intensity per absorbance, that is, quantum efficiency.

Definition: "quantum efficiency (quantum yield) = emission intensity (number of fluorescent photons)/absorbance (number of absorbed photons)"

The content of the activating element M in the host crystal is an amount such that x satisfies $0.01 \leq x \leq 0.8$, preferably $0.05 \leq x \leq 0.6$, more preferably $0.1 \leq x \leq 0.5$, still more preferably $0.2 \leq x \leq 0.4$, for example, 0.3 in the formula (1). When x is less than 0.01, the emission intensity is likely to decrease because the amount of the element M acting as a center of emission is small. When x is more than 0.8, the emission intensity is likely to decrease due to an interference phenomenon called concentration quenching between the elements M.

In a preferred embodiment, the phosphor of the present invention has a hexagonal crystal structure. When the phosphor has a hexagonal crystal structure, the phosphor is protected from external influences such as heat, ion bombardment, and vacuum ultraviolet irradiation, and at the same time, exhibits improved emission intensity. The phosphor of the present invention preferably has a crystal structure represented by ICSD (inorganic crystal structure database) #82105 in an XRD structural pattern measured by X-ray structural diffraction using a CuK$\alpha$ radiation source. In the present specification, X-ray structural diffraction may be referred to as "XRD".

In a more preferred embodiment, the phosphor of the present invention preferably has a peak of the 100 plane at a position of $2\Theta = 15$ to $25°$ or a peak of the 001 plane at a position of $2\Theta = 5$ to $15°$ in XRD measurement using a CuK$\alpha$ radiation source. When the phosphor has a crystal structure having peaks at the above-described positions, the phosphor has a stable structure, protected from external influences such as heat, ion bombardment, and vacuum ultraviolet irradiation, and at the same time, exhibits improved emission intensity.

The phosphor of the present invention has a peak at a position of $2\Theta = 31.7° \pm 0.5$ in XRD measurement using a CuK$\alpha$ radiation source. The full width at half maximum of the XRD peak is preferably less than 0.207. Such a phosphor has high crystallinity, the full width at half maximum of the emission peak is narrowed, and the emission peak is likely to be narrowed. When the full width at half maximum of the XRD peak at $2\Theta = 31.7° \pm 0.5$ is 0.207 or more, the crystallinity of the phosphor decreases, and the full width at half maximum of the emission peak is likely to be widened.

The full width at half maximum of the XRD peak at $2\Theta = 31.7° \pm 0.5$ is more preferably 0.05 to 0.2, still more preferably 0.1 to 0.19, particularly preferably 0.124 to 0.184, and most preferably 0.124 to 0.183. When the full width at half maximum is less than 0.05, the structure of the phosphor is unstable, and sufficient crystallinity may not be obtained.

The full width at half maximum of the XRD peak at $2\Theta = 31.7° \pm 0.5$ can be calculated using integrated powder X-ray diffraction software PDXL (manufactured by Rigaku Corporation). When a plurality of XRD peaks are present at $2\Theta = 31.7° \pm 0.5$, an XRD peak having the highest intensity is selected.

The specific surface area of the phosphor of the present invention is less than 2.7 $m^2/g$. When the specific surface area of the phosphor is small, the amount of the emission center present on the surface of the phosphor is reduced, and oxidation is suppressed, so that the emission intensity of the emission peak present at a position other than green light emission is reduced, and the selectivity of green light emission is improved. When the specific surface area of the phosphor is 2.7 $m^2/g$ or more, oxidation of the emission center is promoted, and the selectivity of green light emission is likely to decrease. Examples of the emission peak present at a position other than green light emission include a peak of red light emission derived from a tetravalent manganese ion.

The specific surface area of the phosphor of the present invention is preferably 0.01 to 2.5 $m^2/g$, more preferably 0.16 to 2.28 $m^2/g$, still more preferably 0.16 to 0.61 $m^2/g$, and particularly preferably 0.16 to 0.24 $m^2/g$. The upper limit and the lower limit of the numerical range in the present specification can be randomly selected and combined. When the specific surface area of the phosphor of the present invention is less than 0.01 $m^2/g$, the emission intensity may decrease.

The specific surface area of the phosphor can be measured by, for example, the BET method. The BET method is one of the methods for measuring the surface area of powder by a gas phase adsorption method. The total surface area per 1 g of sample, that is, the specific surface area can be determined from the adsorption isotherm. As the adsorption gas, nitrogen gas is usually used, and the adsorption amount is measured from a change in pressure or volume of the gas to be adsorbed. The adsorption amount is determined based on the BET equation, and the surface area can be obtained by multiplying the adsorption amount by an area occupied by one adsorbed molecule on the surface of the sample.

In the phosphor of the present invention, D50 of the particle diameter distribution is preferably a value of greater than 4.12 $\mu m$, more preferably 8 to 25 $\mu m$, still more preferably 8.93 to 23.9 $\mu m$, and particularly preferably 21.3 to 23.9 $\mu m$. When D50 of the particle diameter distribution is 4.12 $\mu m$ or less, the full width at half maximum of the emission peak may be widened.

In the phosphor of the present invention, D90 - D10 of the particle diameter distribution is preferably less than 67.4 $\mu m$. In addition, D10 is preferably a value of greater than 1.3 $\mu m$ and 100 $\mu m$ or less. When D90 - D10 of the phosphor is a value of less than 67.4 $\mu m$ and D10 is a value of greater than 1.3 $\mu m$, the uniformity and crystallinity of the phosphor particles are improved, and the emission intensity is improved. When D10 is 1.3 $\mu m$ or less, the crystallinity is insufficient and the emission intensity is likely to decrease, and when D10 is more than 100 $\mu m$, the dispersibility is likely to decrease and the formability during film formation is likely to decrease.

D90 - D10 is more preferably 15.4 to 44.5 $\mu m$, and still more preferably 15.4 to 19.6 $\mu m$. D10 is more preferably 3.5 to 16.0 $\mu m$, and still more preferably 14.9 to 16.0.

The particle diameter distribution of the phosphor can be measured by, for example, a laser diffraction particle diameter analyzer (Mastersizer 2000: manufactured by Malvern Panalytical).

D10, D50, and D90 in the particle diameter distribution are respectively particle diameters corresponding to 10%, 50%, and 90% volume cumulative particle diameters in the cumulative undersize distribution on a volume basis, and D90 - D10 is a value obtained by subtracting the particle diameter of D90 from the particle diameter of D10.

In a preferred embodiment, the phosphor of the present invention is preferably a green light-emitting phosphor which has an excitation wavelength in the vicinity of 450 nm and exhibits an emission peak having a maximum in a range of 510 nm to 550 nm when the emission wavelength is measured in a range of 470 nm to 800 nm. From the viewpoint of improving the color purity of emission, the full width at half maximum of the emission peak is preferably less than 27.7 nm, more preferably 26.4 to 27.3 nm, and still more preferably 26.4 to 27.1 nm.

<Raw materials of phosphor>

As raw materials for producing the phosphor of the present invention, an M compound which is a raw material of an M element, a Mg compound which is a raw material of a Mg element, a Sr compound which is a raw material of a Sr element, and an Al compound which is a raw material of an Al element are used. These compounds are used in powder form.

Examples of the M compound as a raw material of an M element include an oxide containing M, a carbonate containing M, a nitrate containing M, an acetate containing M, a fluoride containing M, and a chloride containing M. Examples of the Mg compound as a raw material of a Mg element include an oxide containing Mg, a carbonate containing Mg, a nitrate containing Mg, an acetate containing Mg, a fluoride containing Mg, and a chloride containing Mg. Specific examples of these M compounds include manganese oxide, manganese carbonate, manganese nitrate, manganese acetate, manganese fluoride, and manganese chloride. Among them, a preferred M compound is manganese carbonate. Examples of the Mg compound include magnesium oxide, magnesium carbonate, magnesium nitrate, magnesium acetate, magnesium fluoride, and magnesium chloride. Among them, a preferred Mg compound is magnesium carbonate.

Examples of the Sr compound include strontium oxide, strontium carbonate, and strontium nitrate. Among them, a preferred Sr compound is strontium carbonate. Examples of the Al compound include aluminum oxide, aluminum carbonate, and aluminum nitrate. Among them, a preferred Al compound is aluminum oxide.

The specific surface area of the aluminum oxide powder used for the raw material of the phosphor is preferably less than 4.4 $m^2/g$, more preferably 0.1 to 3.2 $m^2/g$, still more preferably 0.1 to 0.5 $m^2/g$, and particularly preferably 0.1 to 0.26 $m^2/g$. Use of the aluminum oxide having the specific surface area described above enhances the selectivity of the green light emission of the phosphor.

In the aluminum oxide used for the raw material, D50 is preferably 0.58 to 95 $\mu$m, more preferably 0.88 to 95 $\mu$m, still more preferably 11.4 to 95 $\mu$m, and particularly preferably 11.4 to 20.3 $\mu$m. Use of the aluminum oxide in which D50 is the value described above enhances the selectivity of the green light emission of the phosphor.

<Method for producing phosphor>

When the phosphor of the present invention is produced, first, an M compound, a Mg compound, an Al compound, and a Sr compound are weighed, blended, and mixed so that the ratio of M, Mg, Al, Sr, and O is a predetermined ratio. Mixing of the blended materials can be performed using a mixing apparatus, for example, a ball mill, a sand mill, or a pico mill.

In order to promote the crystallization of the raw material, a flux may be added to the raw material from the viewpoint of promoting the particle growth of the phosphor of the present invention, increasing the particle diameter, and thus enhancing the crystallinity. As the flux, a known flux such as barium fluoride can be used. The amount of the flux used is preferably 1 to 20 wt%, more preferably 2 to 10 wt%, and still more preferably 3 to 7 wt%, based on the total amount of the raw materials.

The mixed raw materials are then fired. Firing is performed in a temperature range of 1,250 to 1,700°C. When the firing temperature is 1,700°C or lower, a desired crystal structure can be obtained without collapsing the host crystal of the phosphor. The firing temperature is preferably 1,300°C to 1,650°C, more preferably 1,400°C to 1,600°C, and still more preferably 1,500°C to 1,600°C. By performing firing in the above-described temperature range, the reactivity of the solid solution is improved, the crystallinity of the phosphor is improved, and the selectivity of green light emission is enhanced.

The firing atmosphere is preferably a mixed atmosphere of hydrogen and nitrogen. The mixed atmosphere used for the firing atmosphere is preferably such that the ratio of hydrogen to nitrogen is 1 : 99 to 100 : 0, and more preferably 5 : 95 to 10 : 90.

When the firing temperature is in the above-described range, the firing time is 1 to 10 hours, and preferably 3 to 7 hours. When the firing time is in this range, a desired crystal structure can be obtained without collapsing the host crystal of the phosphor.

The phosphor of the present invention can be produced through a series of processes including mixing and firing described above. The phosphor of the present invention may be produced by the solid phase reaction method described above, or may be synthesized by another production method, for example, a solution method, or a melt synthesis method.

In a preferred embodiment, the phosphor of the present invention is obtained by firing a raw material mixture containing aluminum oxide powder having a specific surface area of less than 4.4 $m^2/g$ in a temperature range of 1,250 to 1,700°C.

In a preferred embodiment, the aluminum oxide powder has a D50 of 0.58 to 95 $\mu$m.

<Composition>

The phosphor of the present invention can be used as a composition by being dispersed in a monomer, a resin, or a mixture of a monomer and a resin. The resin component of the composition may be a polymer obtained by polymerizing a monomer.

Examples of the monomer used for the composition include methyl (meth)acrylate, ethyl (meth)acrylate, methoxyethyl (meth)acrylate, ethoxyethyl (meth)acrylate, n-propyl (meth)acrylate, isopropyl (meth)acrylate, n-butyl (meth)acrylate, isobutyl (meth)acrylate, tert-butyl (meth)acrylate, 2-ethylhexyl (meth)acrylate, cyclohexyl (meth)acrylate, heptyl (meth)acrylate, octyl (meth)acrylate, nonyl (meth)acrylate, dodecyl (meth)acrylate, lauryl (meth)acrylate, stearyl (meth)acrylate, cyclopentyl (meth)acrylate, cyclohexyl (meth)acrylate, 2-methylcyclohexyl (meth)acrylate, isobornyl (meth)acrylate, adamantyl (meth)acrylate, allyl (meth)acrylate, propargyl (meth)acrylate, phenyl (meth)acrylate, naphthyl (meth)acrylate, benzyl (meth)acrylate, nonylphenylcarbitol (meth)acrylate, 2-hydroxy-3-phenoxypropyl (meth)acrylate, 2-ethylhexylcarbitol (meth)acrylate, 2-hydroxyethyl (meth)acrylate, 2-hydroxypropyl (meth)acrylate, ethylene glycol di(meth)acrylate, triethylene glycol di(meth)acrylate, neopentyl glycol di(meth)acrylate, 1,6-hexanediol di(meth)acrylate, 1,7-heptanediol di(meth)acrylate, 1,8-octanediol di(meth)acrylate, 1,9-nonanediol di(meth)acrylate, 1,10-decanediol di(meth)acrylate, bis[(meth)acryloyloxyethyl]ether of bisphenol A, 3-ethylpentanediol di(meth)acrylate, trimethylolpropane tri(meth)acrylate, pentaerythritol tri(meth)acrylate, pentaerythritol tetra(meth)acrylate, dipentaerythritol penta(meth)acrylate, dipentaerythritol hexa(meth)acrylate, tripentaerythritol octa(meth)acrylate, tripentaerythritol hepta(meth)acrylate, tetrapentaerythritol deca(meth)acrylate, tetrapentaerythritol nona(meth)acrylate, ethylene glycol-modified trimethylolpropane tri(meth)acrylate, propylene glycol-modified trimethylolpropane tri(meth)acrylate, ethylene glycol-modified pentaerythritol tetra(meth)acrylate, propylene glycol-modified pentaerythritol tetra(meth)acrylate, ethylene glycol-modified dipentaerythritol hexa(meth)acrylate, propylene glycol-modified dipentaerythritol hexa(meth)acrylate, caprolactone-modified pentaerythritol tetra(meth)acrylate, caprolactone-modified dipentaerythritol hexa(meth)acrylate, dipentaerythritol penta(meth)acrylate succinic acid monoester, tris(2-(meth)acryloyloxyethyl)isocyanurate, and dicyclopentanyl (meth)acrylate.

Examples of preferred (meth)acrylate include isobornyl (meth)acrylate, stearyl (meth)acrylate, methyl (meth)acrylate, cyclohexyl (meth)acrylate, and dicyclopentanyl (meth)acrylate, from the viewpoint of improving heat resistance, water resistance, light resistance, and emission intensity.

These monomers may be used singly or in combination of two or more types thereof.

The resin used for the composition is not particularly limited, and examples thereof include a (meth)acrylic resin, a styrene resin, an epoxy resin, a urethane resin, and a silicone resin.

The silicone resin is not particularly limited, and examples thereof include addition polymerizable silicone polymerized by an addition polymerization reaction between a silyl group and a vinyl group, and condensation polymerizable silicone polymerized by condensation polymerization of an alkoxysilane. From the viewpoint of improving heat resistance, water resistance, light resistance, and emission intensity, addition polymerizable silicone is preferable.

The silicone resin is preferably one in which an organic group is bonded to a Si element in silicone, and examples of the organic group include functional groups including alkyl groups such as a methyl group, an ethyl group and a propyl group, a phenyl group, and an epoxy group. From the viewpoint of improving heat resistance, water resistance, light resistance, and emission intensity, a phenyl group is preferable.

Examples of the silicone resin include KE-108 (manufactured by Shin-Etsu Chemical Co., Ltd.), KE-1031 (manufactured by Shin-Etsu Chemical Co., Ltd.), KE-109E (manufactured by Shin-Etsu Chemical Co., Ltd.), KE-255 (manufactured by Shin-Etsu Chemical Co., Ltd.), KR-112 (manufactured by Shin-Etsu Chemical Co., Ltd.), KR-251 (manufactured by Shin-Etsu Chemical Co., Ltd.), and KR-300 (manufactured by Shin-Etsu Chemical Co., Ltd.).

These silicones may be used singly or in combination of two or more types thereof.

The proportion of the monomer component and/or the resin component contained in the composition is not particularly limited, but is 10 wt% or more and 99 wt% or less, preferably 20 wt% or more and 80 wt% or less, and more preferably 30 wt% or more and 70 wt% or less.

The composition may contain a curing agent from the viewpoint of curing the monomer component and/or the resin component to improve heat resistance, water resistance, light resistance, and emission intensity. Examples of the curing agent include curing agents having a plurality of functional groups. Examples of the curing agent having a plurality of functional groups include trimethylolpropane triacrylate, pentaerythritol tetraacrylate, ditrimethylolpropane tetraacrylate, dipentaerythritol hexaacrylate, and a mercapto compound containing a thiol group.

The proportion of the curing agent contained in the composition is not particularly limited, but is 0.1 wt% or more and 20 wt% or less, preferably 1 wt% or more and 10 wt% or less, and more preferably 2 wt% or more and 7 wt% or less.

The composition may contain an initiator from the viewpoint of polymerizing the monomer component and/or the resin component to improve heat resistance, water resistance, light resistance, and emission intensity. The initiator may be a photopolymerization initiator or a thermal polymerization initiator.

The thermal polymerization initiator used in the present invention is not particularly limited, and examples thereof include azo-based initiators, peroxides, persulphates, and redox initiators.

The azo-based initiator is not particularly limited, and examples thereof include 2,2'-azobis(4-methoxy-2,4-dimethylvaleronitrile), 2,2'-azobis(2-amidinopropane)dihydrochloride, 2,2'-azobis(2,4-dimethylvaleronitrile), 2,2'-azobis(isobutyronitrile), 2,2'-azobis-2-methylbutyronitrile, 1,1-azobis(1-cyclohexanecarbonitrile), 2,2'-azobis(2-cyclopropylpropionitrile), and 2,2'-azobis(methyl isobutyrate).

The peroxide initiator is not particularly limited, and examples thereof include benzoyl peroxide, acetyl peroxide, lauroyl peroxide, decanoyl peroxide, dicumyl peroxide, dicetyl peroxydicarbonate, t-butylperoxyisopropyl monocarbonate, di(4-t-butylcyclohexyl) peroxydicarbonate, di(2-ethylhexyl) peroxydicarbonate, t-butyl peroxypivalate, and t-butylperoxy-2-ethylhexanoate.

The persulfate initiator is not particularly limited, and examples thereof include potassium persulfate, sodium persulfate, and ammonium persulfate.

The redox (oxidation-reduction) initiator is not particularly limited, but examples thereof include a combination of the persulfate initiator with a reducing agent such as sodium metabisulfite or sodium bisulfite; a system based on an organic peroxide and a tertiary amine, such as a system based on benzoyl peroxide and dimethylaniline; and a system based on an organic hydroperoxide and a transition metal, such as a system based on cumene hydroperoxide and cobalt naphthenate.

Another initiator is not particularly limited, and examples thereof include pinacol such as tetraphenyl-1,1,2,2-ethanediol, and the like.

As the thermal polymerization initiator, an azo-based initiator and a peroxide-based initiator are preferable, and more preferable examples thereof include 2,2'-azobis(methyl isobutyrate), t-butyl peroxypivalate, di(4-t-butylcyclohexyl) peroxydicarbonate, t-butylperoxyisopropyl monocarbonate, and benzoyl peroxide.

The photopolymerization initiator is not particularly limited, and examples thereof include oxime-based compounds such as O-acyloxime compounds, alkylphenone compounds, and acylphosphine oxide compounds.

Examples of the O-acyloxime compound include N-benzoyloxy-1-(4-phenylsulfanylphenyl)butan-1-one-2-imine, N-benzoyloxy-1-(4-phenylsulfanylphenyl)octan-1-one-2-imine, N-benzoyloxy-1-(4-phenylsulfanylphenyl)-3-cyclopentylpropan-1-one-2-imine, N-acetoxy-1-[9-ethyl-6-(2-methylbenzoyl)-9H-carbazol-3-yl]ethane-1-imine, N-acetoxy-1-[9-ethyl-6-{2-methyl-4-(3,3-dimethyl-2,4-dioxacyclopentanylmethyloxy)benzoyl}-9H-carbazol-3-yl]ethane-1-imine, N-acetoxy-1-[9-ethyl-6-(2-methylbenzoyl)-9H-carbazol-3-yl]-3-cyclopentylpropane-1-imine, N-benzoyloxy-1-[9-ethyl-6-(2-methylbenzoyl)-9H-carbazol-3-yl]-3-cyclopentylpropan-1-one-2-imine, N-acetyloxy-1-[4-(2-hydroxyethyloxy)phenylsulfanylphenyl]propan-1-one-2-imine, and N-acetyloxy-1-[4-(1-methyl-2-methoxyethoxy)-2-methylphenyl]-1-(9-ethyl-6-nitro-9H-carbazol-3-yl)methane-1-imine.

Commercially available products such as Irgacure (trade name) OXE01, Irgacure (trade name) OXE02, and Irgacure (trade name) OXE03 (as described above, manufactured by BASF), and N-1919, NCI-930, and NCI-831 (as described above, manufactured by ADEKA CORPORATION) may be used.

Examples of the alkylphenone compound include 2-methyl-2-morpholino-1-(4-methylsulfanylphenyl)propan-1-one, 2-dimethylamino-1-(4-morpholinophenyl)-2-benzylbutan-1-one, 2-(dimethylamino)-2-[(4-methylphenyl)methyl]-1-[4-(4-morpholinyl)phenyl]butan-1-one, 2-hydroxy-2-methyl-1-phenylpropan-1-one, 2-hydroxy-2-methyl-1-[4-(2-hydroxyethoxy)phenyl]propan-1-one, 1-hydroxycyclohexylphenyl ketone, oligomer of 2-hydroxy-2-methyl-1-(4-isopropenylphenyl)propan-1-one, $\alpha,\alpha$-diethoxyacetophenone, and benzyldimethylketal.

Commercially available products such as Omnirad (trade name) 369, Omnirad (trade name) 907, Omnirad (trade name) 379 (as described above, manufactured by IGM Resins B.V.) may be used.

Examples of the acylphosphine oxide compound include phenylbis(2,4,6-trimethylbenzoyl)phosphine oxide (for example, trade name "Omnirad 819" (manufactured by IGM Resins B.V.)) and 2,4,6-trimethylbenzoyldiphenylphosphine oxide. Further examples of the photopolymerization initiator include benzoin compounds such as benzoin, benzoin methyl ether, benzoin ethyl ether, benzoin isopropyl ether, and benzoin isobutyl ether; benzophenone compounds such as benzophenone, methyl-o-benzoylbenzoate, 4-phenylbenzophenone, 4-benzoyl-4'-methyldiphenylsulfide, 3,3',4,4'-tetra(tert-butylperoxycarbonyl)benzophenone, 2,4,6-trimethylbenzophenone, and 4,4'-di(N,N'-dimethylamino)-benzophenone; xanthone compounds such as 2-isopropylthioxanthone and 2,4-diethylthioxanthone; anthracene compounds such as 9,10-dimethoxyanthracene, 2-ethyl-9,10-dimethoxyanthracene, 9,10-diethoxyanthracene, and 2-ethyl-9,10-diethoxyanthracene; quinone compounds such as 9,10-phenanthrene quinone, 2-ethylanthraquinone, and camphorquinone; benzyl, methyl phenylglyoxylate, and a titanocene compound.

The composition may contain an antioxidant from the viewpoint of suppressing oxidation of the composition and improving heat resistance, water resistance, light resistance, and emission intensity. Examples of the antioxidant include amine-based antioxidants, sulfur-based antioxidants, phenol-based antioxidants, phosphorus-based antioxidants, phosphorus-phenol-based antioxidants, and metal-compound-based antioxidants. The antioxidant preferably includes at least one selected from the group consisting of amine-based antioxidants, sulfur-based antioxidants, phenol-based antioxidants, and phosphorus-based antioxidants, and more preferably includes at least one selected from the group consisting of sulfur-based antioxidants, phenol-based antioxidants, and phosphorus-based antioxidants.

The amine-based antioxidant is an antioxidant having an amino group in the molecule. Examples of the amine-based antioxidant include naphthylamine-based antioxidants such as 1-naphthylamine, phenyl-1-naphthylamine, p-octylphenyl-1-naphthylamine, p-nonylphenyl-1-naphthylamine, p-dodecylphenyl-1-naphthylamine, and phenyl-2-naphthylamine; phenylenediamine-based antioxidants such as N,N'-diisopropyl-p-phenylenediamine, N,N'-diisobutyl-p-phenylenediamine, N,N'-diphenyl-p-phenylenediamine, N,N'-di-$\beta$-naphthyl-p-phenylenediamine, N-phenyl-N'-isopropyl-p-phenylenediamine, N-cyclohexyl-N'-phenyl-p-phenylenediamine, N-1,3-dimethylbutyl-N'-phenyl-p-phenylenediamine, dioctyl-p-phenylenediamine, phenylhexyl-p-phenylenediamine, and phenyloctyl-p-phenylenediamine; diphenylamine-based antioxidants such as dipyridylamine, diphenylamine, p,p'-di-n-butyldiphenylamine, p,p'-di-tert-butyldiphenylamine, p,p'-di-tert-pentyldiphenylamine, p,p'-dioctyldiphenylamine, p,p'-dinonyldiphenylamine, p,p'-didecyldiphenylamine, p,p'-didodecyldiphenylamine, p,p'-distyryldiphenylamine, p,p'-dimethoxydiphenylamine, 4,4'-bis(4-$\alpha,\alpha$-dimethylbenzoyl)diphenylamine, p-isopropoxydiphenylamine, and dipyridylamine; phenothiazinebased antioxidants such as phenothiazine, N-methylphenothiazine, N-ethylphenothiazine, 3,7-dioctylphenothiazine, phenothiazine carboxylic acid ester, and phenoselenazine; bis(2,2,6,6-tetramethyl-4-piperidinyl)sebacate (trade name "Tinuvin 770" manufactured by BASF); and [(4-methoxyphenyl)-methylene]-bis(1,2,2,6,6-pentamethyl-4-piperidinyl)malonate (trade name "Hostavin PR31" manufactured by Clariant).

The sulfur-based antioxidant is an antioxidant having a sulfur atom in the molecule. Examples of the sulfur-based antioxidant include dialkylthiodipropionate compounds (for example, "SUMILIZER TPM" (trade name, manufactured by Sumitomo Chemical Co., Ltd.)) such as dilauryl thiodipropionate, dimyristyl, and distearyl; β-alkylmercaptopropionic acid ester compounds of polyols, such as tetrakis[methylene(3-dodecylthio)propionate]methane and tetrakis[methylene(3-laurylthio)propionate]methane; and 2-mercaptobenzimidazole.

The phenol-based antioxidant is an antioxidant having a phenolic hydroxy group in the molecule. In the present specification, a phosphorus-phenol-based antioxidant having both a phenolic hydroxy group and a phosphoric acid ester structure, or having both a phenolic hydroxy group and a phosphorous acid ester structure is classified as a phenol-based antioxidant. Examples of the phenol-based antioxidant include 1,1,3-tris(2-methyl-4-hydroxy-5-tert-butylphenyl)butane, 4,4'-butylidene-bis(3-methyl-6-tertbutylphenol), 1,3,5-trimethyl-2,4,6-tris(3,5-di-tert-butyl-4-hydroxybenzyl)benzene, 2-tert-butyl-6-(3-tert-butyl-2-hydroxy-5-methylbenzyl)-4-methylphenyl acrylate, (tetrakis[methylene-3-(3,5-di-tert-butyl-4-hydroxyphenyl)propionate]methane, pentaerythritol tetrakis[3-(3,5-di-tert-butyl-4-hydroxyphenyl)propionate], octadecyl-3-(3,5-di-tert-butyl-4-hydroxyphenyl)propionate ("Irganox 1076" (trade name, manufactured by BASF)), 3,3',3",5,5',5"-hexa-tert-butyl-a,a',a"-(mesitylene-2,4,6-triyl)tri-p-cresol, 1,3,5-tris(3,5-di-tert-butyl-4-hydroxybenzyl)-1,3,5-triazine-2,4,6(1H,3H,5H)-trione, 1,3,5-tris((4-tert-butyl-3-hydroxy-2,6-xylyl)methyl)-1,3,5-triazine-2,4,6(1H,3H,5H)-trione, thiodiethylenebis[3-(3,5-di-tert-butyl-4-hydroxyphenyl)propionate], benzenepropanoic acid, 3,5-bis(1,1-dimethylethyl)-4-hydroxy C7-C9 side-chain alkyl ester, 4,6-bis(octylthiomethyl)-o-cresol, 2,4-bis(n-octylthio)-6-(4-hydroxy-3',5'-di-tert-butylanilino)-1,3,5-triazine, 3,9-bis(2-(3-(3-tert-butyl-4-hydroxy-5-methylphenyl)propionyloxy)-1,1-dimethylethyl)-2,4,8,10-tetraoxaspiro(5,5)undecane (trade name "ADK STAB AO-80" manufactured by ADEKA CORPORATION), triethylene glycol-bis[3-(3-tert-butyl-5-methyl-4-hydroxyphenyl)propionate], 4,4'-thiobis(6-tert-butyl-3-methylphenol), tris-(3,5-di-tert-butyl-4-hydroxybenzyl)-isocyanurate, 1,3,5-tris(4-tert-butyl-3-hydroxy-2,6-dimethylbenzyl)-isocyanurate, 1,6-hexanediol-bis[3-(3,5-di-tert-butyl-4-hydroxyphenyl)propionate], N,N'-hexamethylenebis(3,5-di-tert-butyl-4-hydroxy-hydrocinnamamide), 1,3,5-trimethyl-2,4,6-tris(3,5-di-tert-butyl-4-hydroxybenzyl)benzene, 1,6-hexanediol-bis-[3-(3,5-di-tert-butyl-4-hydroxyphenyl)propionate], 2,2'-methylenebis(4-methyl-6-tert-butylphenol), 1,3,5-tris(4-hydroxybenzyl)benzene, 6,6'-di-tert-butyl-4,4'-butylidenedi-m-cresol (trade name "ADK STAB AO-40" manufactured by ADEKA CORPORATION), "Irganox-3125" (trade name, manufactured by BASF), "SUMILIZER BHT" (trade name, manufactured by Sumitomo Chemical Co., Ltd.), "SUMILIZER GA-80" (trade name, manufactured by Sumitomo Chemical Co., Ltd.), "SUMILIZER GS" (trade name, manufactured by Sumitomo Chemical Co., Ltd.), "CYANOX 1790" (trade name, manufactured by Cytec Industries Inc.), and Vitamin E (manufactured by Eisai Co., Ltd.).

Examples of the phosphorus-phenol-based antioxidant include 2,10-dimethyl-4,8-di-tert-butyl-6-[3-(3,5-di-tert-butyl-4-hydroxyphenyl)propoxy]-12H-dibenzo[d,g][1,3,2]dioxaphosphocin, 2,4,8,10-tetra-tert-butyl-6-[3-(3,5-di-tert-butyl-4-hydroxyphenyl)propoxy]dibenzo[d,f] [1,3,2]dioxaphosphepin, and 2,4,8,10-tetra-tert-butyl-6-[3-(3,5-di-tert-butyl-4-hydroxyphenyl)propionyloxy]-dibenzo[d,f][1,3,2]dioxaphosphepin (trade name "SUMILIZER GP" manufactured by Sumitomo Chemical Co., Ltd.).

The phosphorus-based antioxidant is an antioxidant having a phosphoric acid ester structure or a phosphorous acid ester structure. Examples of the phosphorus-based antioxidant include diphenylisooctyl phosphite, 2,2'-methylenebis(4,6-di-tert-butylphenyl)octyl phosphite, diphenylisodecyl phosphite, diphenylisodecyl phosphite, triphenyl phosphate, tributyl phosphate, diisodecylpentaerythritol diphosphite, distearyl pentaerythritol diphosphite, cyclic neopentanetetrylbis(2,4-di-tert-butylphenyl)phosphite, cyclic neopentanetetrylbis(2,6-di-tert-butylphenyl) phosphite, cyclic neopentanetetrylbis(2,6-di-tert-butyl-4-methylphenyl)phosphite, 6-[3-(3-tert-butyl-4-hydroxy-5-methylphenyl)propoxy]-2,4,8,10-tetra-tert-butylbenzo[d,f] [1,3,2]dioxaphosphepin, tris(nonylphenyl)phosphite (trade name, "ADK STAB 1178" manufactured by ADEKA CORPORATION), tris(mono- and dinonylphenyl mixed) phosphite, diphenylmono(tridecyl) phosphite, 2,2'-ethylidenebis(4,6-di-tertbutylphenol)fluorophosphite, phenyldiisodecyl phosphite, tris(2-ethylhexyl) phosphite, tris(isodecyl) phosphite, tris(tridecyl) phosphite, tris(2,4-di-tert-butylphenyl) phosphite, tetrakis(2,4-di-tert-butylphenyl)-4,4'-biphenylene-di-phosphonite, 4,4'-isopropylidenediphenyltetraalkyl(C12 to C15)diphosphite, 4,4'-butylidenebis(3-methyl-6-tert-butylphenyl)-ditridecyl phosphite, bis(nonylphenyl)pentaerythritol diphosphite, bis(2,4-di-tert-butylphenyl)pentaerythritol-di-phosphite, cyclicneopentanetetraylbis(2,6-di-tert-butyl-4-methylphenyl-phosphite), 1,1,3-tris(2-methyl-4-ditridecylphosphite-5-tert-butylphenyl)butane, tetrakis(2,4-di-tert-butyl-5-methylphenyl)-4,4'-biphenylene diphosphonite, tri-2-ethylhexyl phosphite, triisodecyl phosphite, tristearyl phosphite, phenyl diisodecyl phosphite, trilauryl trithiophosphite, distearyl pentaerythritol diphosphite, tris(nonylphenyl)phosphite, tris[2-[[2,4,8,10-tetratert-butyldibenzo[d,f][1,3,2]dioxaphosphin-6-yl]oxy]ethyl]amine, bis(2,4-bis(1,1-dimethylethyl)-6-methylphenyl)ethyl ester phosphorous acid, 3,9-bis(2,6-di-tert-butyl-4-methylphenoxy)-2,4,8,10-tetraoxa-3,9-diphosphaspiro[5.5]undecane, bis(2,4-di-tert-butylphenyl)pentaerythritol diphosphite, 2,2'-methylenebis(4,6-di-tert-butyl-1-phenyloxy) (2-ethylhexyloxy)phosphorus, triphenyl phosphite, 4,4'-butylidene-bis(3-methyl-6-tert-butylphenylditridecyl)phosphite, octadecyl phosphite, 9,10-dihydro-9-oxa-10-phosphaphenanthrene-10-oxide, 10-(3,5-di-tert-butyl-4-hydroxybenzyl)-9,10-dihydro-9-oxa-10-phosphaphenanthrene-10-oxide, 10-decyloxy-9,10-dihydro-9-oxa-10-phosphaphenanthrene-10-oxide, 2,2-methylenebis(4,6-di-tert-butylphenyl)octyl phosphite, tetrakis(2,4-di-tert-butylphenyl)[1,1-biphenyl]-4,4'-diylbisphosphonite, bis[2,4-bis(1,1-dimethylethyl)-6-methylphenyl]ethyl ester, phosphonic acid, "ADK STAB 329K" (trade name, manufactured by ADEKA CORPORATION), "ADK STAB PEP36" (trade name, manufactured by ADEKA CORPORATION), "ADK STAB PEP-8" (trade name, manufactured by ADEKA CORPORATION), "Sandstab P-EPQ" (trade name, manufactured by Clariant), "Weston 618" (trade name, manufactured by GE), "Weston 619G" (trade name, manufactured by GE), and "ULTRANOX 626" (trade name, manufactured by GE).

The proportion of the antioxidant contained in the composition is not particularly limited, but is 0.1 wt% or more and 20 wt% or less, preferably 1 wt% or more and 10 wt% or less, and more preferably 2 wt% or more and 7 wt% or less.

The composition may contain a light scattering material from the viewpoint of scattering light having passed through the composition to increase the amount of light absorbed by the composition, and improve the emission intensity. The light scattering material is not particularly limited, and examples thereof include polymer fine particles and inorganic fine particles. Examples of a polymer used for the polymer fine particles include an acrylic resin, an epoxy resin, a silicone resin, and a urethane resin.

Examples of the inorganic fine particles used for the light scattering material include fine particles containing known inorganic compounds such as oxides, hydroxides, sulfides, nitrides, carbides, chlorides, bromides, iodides, and fluorides.

In the light scattering material, examples of the oxide contained in the inorganic fine particles include known oxides such as silicon oxide, aluminum oxide, zinc oxide, niobium oxide, zirconium oxide, titanium oxide, magnesium oxide, cerium oxide, yttrium oxide, strontium oxide, barium oxide, calcium oxide, tungsten oxide, indium oxide, gallium oxide, and titanium oxide, or mixtures thereof. Among them, aluminum oxide, zinc oxide, and niobium oxide are preferable, aluminum oxide and niobium oxide are more preferable, and niobium oxide is most preferable.

In the light scattering material, examples of the aluminum oxide contained in the inorganic fine particles include known aluminum oxides such as α-alumina, γ-alumina, θ-alumina, δ-alumina, η-alumina, κ-alumina, and χ-alumina. Among them, α-alumina and γ-alumina are preferable, and α-alumina is more preferable.

In the light scattering material, the aluminum oxide may be a commercially available product, and may be alumina obtained by firing raw materials such as aluminum nitrate, aluminum chloride, and aluminum alkoxide. Examples of commercially available products of aluminum oxide include AKP-20 (manufactured by Sumitomo Chemical Co., Ltd.), AKP-30 (manufactured by Sumitomo Chemical Co., Ltd.), AKP-50 (manufactured by Sumitomo Chemical Co., Ltd.), AKP-53 (manufactured by Sumitomo Chemical Co., Ltd.), AKP-3000 (manufactured by Sumitomo Chemical Co., Ltd.), AA-02 (manufactured by Sumitomo Chemical Co., Ltd.), AA-03 (manufactured by Sumitomo Chemical Co., Ltd.), AA-04 (manufactured by Sumitomo Chemical Co., Ltd.), AA-05 manufactured by Sumitomo Chemical Co., Ltd.), AA-07 (manufactured by Sumitomo Chemical Co., Ltd.), AA-1.5 (manufactured by Sumitomo Chemical Co., Ltd.), AA-3 (manufactured by Sumitomo Chemical Co., Ltd.), and AA-18 (manufactured by Sumitomo Chemical Co., Ltd.). From the viewpoint of absorbance, AA-02 (manufactured by Sumitomo Chemical Co., Ltd.), AA-3 (manufactured by Sumitomo Chemical Co., Ltd.), AA-18 (manufactured by Sumitomo Chemical Co., Ltd.), AKP-20 (manufactured by Sumitomo Chemical Co., Ltd.), AKP-3000 (manufactured by Sumitomo Chemical Co., Ltd.), AKP-53 (manufactured by Sumitomo Chemical Co., Ltd.), AKP-30 (manufactured by Sumitomo Chemical Co., Ltd.), and AKP-50 (manufactured by Sumitomo Chemical Co., Ltd.) are preferable, and AA-02 (manufactured by Sumitomo Chemical Co., Ltd.), AA-3 (manufactured by Sumitomo Chemical Co., Ltd.), AKP-53 (manufactured by Sumitomo Chemical Co., Ltd.), AKP-3000 (manufactured by Sumitomo Chemical Co., Ltd.), AKP-30 (manufactured by Sumitomo Chemical Co., Ltd.), and AKP-50 (manufactured by Sumitomo Chemical Co., Ltd.) are more preferable.

In the light scattering material, examples of the hydroxide contained in the inorganic fine particles include known hydroxides such as aluminum hydroxide, zinc hydroxide, magnesium hydroxide, cerium hydroxide, yttrium hydroxide, strontium hydroxide, barium hydroxide, calcium hydroxide, indium hydroxide, and gallium hydroxide, or mixtures thereof. Among them, aluminum hydroxide and zinc hydroxide are preferable.

In the light scattering material, examples of the sulfide contained in the inorganic fine particles include known sulfides such as silicon sulfide, aluminum sulfide, zinc sulfide, niobium sulfide, zirconium sulfide, titanium sulfide, magnesium sulfide, cerium sulfide, yttrium sulfide, strontium sulfide, barium sulfide, calcium sulfide, tungsten sulfide, indium sulfide, and gallium sulfide, or mixtures thereof. Among them, aluminum sulfide, zinc sulfide, niobium sulfide are preferable, zinc sulfide and niobium sulfide are more preferable, and niobium sulfide is most preferable.

In the light scattering material, examples of the nitride contained in the inorganic fine particles include known nitrides such as silicon nitride, aluminum nitride, zinc nitride, niobium nitride, zirconium nitride, titanium nitride, magnesium nitride, cerium nitride, yttrium nitride, strontium nitride, barium nitride, calcium nitride, tungsten nitride, indium nitride, and gallium nitride, or mixtures thereof. Among them, aluminum nitride, zinc nitride, and niobium nitride are preferable, aluminum nitride and niobium nitride are more preferable, and niobium nitride is most preferable.

In the light scattering material, examples of the carbide contained in the inorganic fine particles include known carbides such as silicon carbide, aluminum carbide, zinc carbide, niobium carbide, zirconium carbide, titanium carbide, magnesium carbide, cerium carbide, yttrium carbide, strontium carbide, barium carbide, calcium carbide, tungsten carbide, indium carbide, and gallium carbide, or mixtures thereof. Among them, aluminum carbide, zinc carbide, and niobium carbide are preferable, aluminum carbide and niobium carbide are more preferable, and niobium carbide is most preferable.

In the light scattering material, examples of the chloride contained in the inorganic fine particles include known chlorides such as silicon chloride, aluminum chloride, zinc chloride, niobium chloride, zirconium chloride, titanium chloride, magnesium chloride, cerium chloride, yttrium chloride, strontium chloride, barium chloride, calcium chloride, tungsten chloride, indium chloride, and gallium chloride, or mixtures thereof. Among them, aluminum chloride, zinc chloride, and niobium chloride are preferable, aluminum chloride and niobium chloride are more preferable, and niobium chloride is most preferable.

In the light scattering material, examples of the bromide contained in the inorganic fine particles include known bromides such as silicon bromide, aluminum bromide, zinc bromide, niobium bromide, zirconium bromide, titanium bromide, magnesium bromide, cerium bromide, yttrium bromide, strontium bromide, barium bromide, calcium bromide, tungsten bromide, indium bromide, and gallium bromide, or mixtures thereof. Among them, aluminum bromide, zinc bromide and niobium bromide are preferable, aluminum bromide and niobium bromide are more preferable, and niobium bromide is most preferable.

In the light scattering material, examples of the iodide contained in the inorganic fine particles include known iodides such as silicon iodide, aluminum iodide, zinc iodide, niobium iodide, zirconium iodide, titanium iodide, magnesium iodide, and gallium iodide, cerium iodide, yttrium iodide, strontium iodide, barium iodide, calcium iodide, tungsten iodide, and indium iodide, or mixtures thereof. Among them, aluminum iodide, zinc iodide, and niobium iodide are preferable, aluminum iodide and niobium iodide are more preferable, and niobium iodide is most preferable.

In the light scattering material, examples of the fluoride contained in the inorganic fine particles include known fluorides such as silicon fluoride, aluminum fluoride, zinc fluoride, niobium fluoride, zirconium fluoride, titanium fluoride, magnesium fluoride, cerium fluoride, yttrium fluoride, strontium fluoride, barium fluoride, calcium fluoride, tungsten fluoride, indium fluoride, and gallium fluoride, or mixtures thereof. Among them, aluminum fluoride, zinc fluoride, and niobium fluoride are preferable, aluminum fluoride and niobium fluoride are more preferable, and niobium fluoride is most preferable.

As the light scattering material, aluminum oxide, silicon oxide, zinc oxide, titanium oxide, niobium oxide, and zirconium oxide are preferable, and aluminum oxide is preferable, from the viewpoint of scattering light having passed through the composition to improve the amount of light absorbed by the composition and improve the emission intensity.

The particle diameter of the light scattering material contained in the composition is not particularly limited, but is 0.1 $\mu$m or more and 50 $\mu$m or less, preferably 0.3 $\mu$m or more and 10 $\mu$m or less, and more preferably 0.5 $\mu$m or more and 5 $\mu$m or less.

The proportion of the light scattering material contained in the composition is not particularly limited, but is 0.1 wt% or more and 20 wt% or less, preferably 1 wt% or more and 10 wt% or less, and more preferably 2 wt% or more and 7 wt% or less.

The composition may contain another light-emitting material other than the phosphor of the present invention, from the viewpoint of adjusting the color of light emitted by the composition and achieving a wide color gamut. Examples of another light-emitting material other than the phosphor of the present invention contained in the composition include phosphors other than the phosphor of the present invention, and quantum dots.

The quantum dot contained in the composition is not particularly limited as long as it is a quantum dot particle capable of emitting fluorescence in a visible light wavelength range. For example, the quantum dot can be selected from the group consisting of Group II-VI semiconductor compounds; Group III-V semiconductor compounds; Group IV-VI semiconductor compounds; Group IV elements or compounds containing the Group IV element; and combinations thereof. These can be used singly or in combination of two or more types thereof.

The Group II-VI semiconductor compound can be selected from the group consisting of a binary compound selected from the group consisting of CdS, CdSe, CdTe, ZnS, ZnSe, ZnTe, ZnO, HgS, HgSe, HgTe, and a mixture thereof; a ternary compound selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, and a mixture thereof; and a quaternary compound selected from the group consisting of CdZnSeS, CdZnSeTe, CdZnSTe, CdHgSeS, CdHgSeTe, CdHgSTe, HgZnSeS, HgZnSeTe, HgZnSTe, and a mixture thereof.

The Group III-V semiconductor compound can be selected from the group consisting of a binary compound selected from the group consisting of GaN, GaP, GaAs, GaSb, AlN, AlP, AlAs, AlSb, InN, InP, InAs, InSb, and a mixture thereof; a ternary compound selected from the group consisting of GaNP, GaNAs, GaNSb, GaPAs, GaPSb, AlNP, AlNAs, AlNSb, AlPAs, AlPSb, InNP, InNAs, InNSb, InPAs, InPSb, GaAlNP, and a mixture thereof; and a quaternary compound selected from the group consisting of GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and a mixture thereof.

The Group IV-VI semiconductor compound can be selected from the group consisting of a binary compound selected from the group consisting of SnS, SnSe, SnTe, PbS, PbSe, PbTe, and a mixture thereof; a ternary compound selected from the group consisting of SnSeS, SnSeTe, SnSTe, PbSeS, PbSeTe, PbSTe, SnPbS, SnPbSe, SnPbTe, and a mixture thereof; and a quaternary compound selected from the group consisting of SnPbSSe, SnPbSeTe, SnPbSTe, and a mixture thereof.

The Group IV element or the compound containing the Group IV element can be selected from the group consisting of an element compound selected from the group consisting of Si, Ge, and a mixture thereof; and a binary compound selected from the group consisting of SiC, SiGe, and a mixture thereof.

The quantum dot has a homogeneous single structure; a double structure such as a core-shell structure, or a gradient structure; or a mixed structure thereof.

In the double structure of the core-shell structure, substances constituting the core and shell can be composed of the above-described semiconductor compounds different from each other. The core may contain, for example, one or more substances selected from the group consisting of CdSe, CdS, ZnS, ZnSe, ZnTe, CdTe, CdSeTe, CdZnS, PbSe, AgInZnS, HgS, HgSe, HgTe, GaN, GaP, GaAs, InP, InAs, and ZnO, but is not limited thereto. The shell may contain, for example, one or more substances selected from the group consisting of CdSe, ZnSe, ZnS, ZnTe, CdTe, PbS, TiO, SrSe, and HgSe, but is not limited thereto.

The quantum dot is preferably InP or CdSe from the viewpoint of obtaining white light.

The diameter of the quantum dot is not particularly limited, and red, green, and blue quantum dot particles can be classified by the particle diameter, and the particle diameter decreases in the order of red, green, and blue. Specifically, the red quantum dot particles may have a particle diameter of 5 nm or more and 10 nm or less, the green quantum dot particles may have a particle diameter of more than 3 nm and 5 nm or less, and the blue quantum dot particles may have a particle diameter of 1 nm or more and 3 nm or less. Upon irradiation with light, the red quantum dot particles emit red light, the green quantum dot particles emit green light, and the blue quantum dot particles emit blue light.

The phosphor other than the phosphor of the present invention contained in the composition is not particularly limited, and examples thereof include sulfide-based phosphors, oxide-based phosphors, nitride-based phosphors, and fluoride-based phosphors. These may be used singly or in combination of two or more types thereof.

Examples of the sulfide-based phosphor include $CaS : Eu$, $SrS : Eu$, $SrGa_2S_4 : Eu$, $CaGa_2S_4 : Eu$, $Y_2O_2S : Eu$, $La_2O_2S : Eu$, and $Gd_2O_2S : Eu$.

Specific examples of the oxide-based phosphor include $(Ba,Sr)_3SiO_5 : Eu$, $(Ba,Sr)_2SiO_4 : Eu$, $Tb_3Al_5O_{12} : Ce$, and $Ca_3Sc_2Si_3O_{12} : Ce$.

Specific examples of the nitride-based phosphor include $CaSi_5N_8 : Eu$, $Sr_2Si_5N_8 : Eu$, $Ba_2Si_5N_8 : Eu$, $(Ca,Sr,Ba)_2Si_5N_8 : Eu$, $Cax(Al,Si)_{12}(O,N)_{16} : Eu$ $(0 < x \leq 1.5)$, $CaSi_2O_2N_2 : Eu$, $SrSi_2O_2N_2 : Eu$, $BaSi_2O_2N_2 : Eu$, $(Ca,Sr,Ba)Si_2O_2N_2 : Eu$, $CaAl_2Si_4N_8 : Eu$, $CaSiN_2 : Eu$, $CaAlSiN_3 : Eu$, and $(Sr,Ca)AlSiN_3 : Eu$.

Specific examples of the fluoride-based phosphor are not particularly limited, and include $K_2TiF_6 : Mn^{4+}$, $Ba_2TiF_6 : Mn^{4+}$, $Na_2TiF_6 : Mn^{4+}$, $K_3ZrF_7 : Mn^{4+}$, and $K_2SiF_6 : Mn^{4+}$.

Specific examples of the other phosphor are not particularly limited, and include YAG-based phosphors such as $(Y,Gd)_3(Al,Ga)_5O_{12} : Ce(YAG : Ce)$; SiAlON-based phosphors such as $Lu(Si,Al)_{12}(O,N)_{16} : Eu$; and perovskite phosphors also having a perovskite structure.

The phosphor other than the phosphor of the present invention contained in the composition is preferably a red phosphor, and is preferably $K_2SiF_6 : Mn^{4+}$, from the viewpoint of obtaining white light.

The proportion of the light-emitting material other than the phosphor of the present invention contained in the composition is not particularly limited, but is 0.1 wt% or more and 90 wt% or less, preferably 1 wt% or more and 80 wt% or less, and more preferably 5 wt% or more and 60 wt% or less.

<Film>

The phosphor of the present invention can be used in the form of a film by processing the shape of the resin composition. The shape of the film is not particularly limited, and may be any shape such as a sheet shape or a bar shape. In the present specification, the term "bar shape" means, for example, a belt shape in plan view extending in one direction. Examples of the belt shape in plan view include a plate shape having four sides with different lengths. The thickness of the film may be 0.01 $\mu$m to 1,000 mm, 0.1 $\mu$m to 10 mm, or 1 $\mu$m to 1 mm. In the present specification, the thickness of the film refers to a distance between the front surface and the back surface in the thickness direction of the film, assuming that a side having the smallest value among the length, width, and height of the film is defined as the "thickness direction". Specifically, the thickness of the film is measured at any three points of the film with a micrometer, and the average value of the measured values at the three points is taken as the thickness of the film. The film may be a single layer or a multilayer. In the case of a multilayer, respective layers may be composed of the same type of compositions of the embodiment, or may be composed of different types of compositions the embodiment.

<Glass molded body>

The phosphor of the present invention can be used as a glass molded body by being dispersed in glass.

A glass component used for the glass composition is not particularly limited, and examples thereof include $SiO_2$, $P_2O_5$, $GeO_2$, $BeF_2$, $As_2S_3$, $SiSe_2$, $GeS_2$, $TiO_2$, $TeO_2$, $Al_2O_3$, $Bi_2O_3$, $V_2O_5$, $Sb_2O_5$, PbO, CuO, $ZrF_4$, $AlF_3$, $InF_3$, $ZnCl_2$, $ZnBr_2$, $Li_2O$, $Na_2O$, $K_2O$, MgO, BaO, CaO, SrO, LiCl, $BaCl$, $BaF_2$, and $LaF_3$. Among them, $SiO_2$ or $Bi_2O_3$ is preferably contained as a glass component from the viewpoint of improving durability, heat resistance, and light resistance. The glass component may be one type or two or more types.

The proportion of the glass component contained in the glass molded body is not particularly limited, but is 10 wt% or more and 99 wt% or less, preferably 20 wt% or more and 80 wt% or less, and more preferably 30 wt% or more and 70 wt% or less.

The glass molded body may contain a light scattering material from the viewpoint of scattering light having passed through the molded body to improve the amount of light absorbed by the glass molded body and improve the emission intensity. As the light scattering material, the same inorganic fine particles as those of the light scattering material used for the resin composition can be used.

The amount of the light scattering material added to the glass molded body can be the same as the amount of the light scattering material used for the resin composition.

The glass molded body may contain another light-emitting material other than the phosphor of the present invention from the viewpoint of adjusting the color of light emitted from the glass molded body and achieving a wide color gamut. As another light-emitting material other than the phosphor of the present invention contained in the glass molded body, the same light-emitting material as that used for the resin composition can be used.

The amount of the light-emitting material added to the glass molded body can be the same as the amount of the light-emitting material used for the resin composition.

The shape of the glass molded body is not particularly limited, and examples thereof include a plate shape, a rod shape, a cylindrical shape, and a wheel shape.

<Light-emitting element>

The phosphor of the present invention can constitute a light-emitting element together with a light source. As the light source, in particular, an LED that emits ultraviolet light or visible light in a wavelength range of 350 nm to 500 nm can be used. When the phosphor of the present invention is irradiated with light having the above wavelength, the phosphor emits green light having a peak at a wavelength of 510 nm to 550 nm. Therefore, the phosphor of the present invention can constitute a white light-emitting element by, for example, using an ultraviolet LED or a blue LED as a light source and combining the phosphor of the present invention with other red phosphors.

<Light-emitting device>

The phosphor of the present invention can constitute a white light-emitting element as described above, and the white light-emitting element can be used as a member of a light-emitting device. In the light-emitting device, a light-emitting element is irradiated with light from a light source, the irradiated light-emitting element emits light, and the light is extracted.

<Display>

The light-emitting element including the phosphor of the present invention and a light source can be used for a display. Examples of such a display include liquid crystal displays that control the transmittance of light derived from a light-emitting element with liquid crystal and that can select and extract transmitted light as red light, blue light, and green light by a color filter.

<Phosphor wheel>

The phosphor of the present invention can be used for producing a phosphor wheel. The phosphor wheel is a member having a disk-shaped substrate and a phosphor layer formed on the surface of the substrate. The phosphor wheel absorbs excitation light emitted from a light source, are excited with the excitation light, and emits converted light having a different wavelength from the excitation light. For example, the phosphor wheel absorbs blue excitation light, and emits converted light that is different from the blue excitation light and converted by the phosphor layer and at the same time, reflects the blue excitation light, thereby converting the blue excitation light into light of various colors with the converted light and the reflected light, or only the converted light.

<Projector>

The phosphor of the present invention can be used as a member constituting a projector produced using the phosphor wheel. The projector is a display device including a light source, a phosphor wheel, a mirror device, and a projection optical system.

EXAMPLES

Hereinafter, the present invention will be described in more detail with reference to Examples. The present invention is not limited to these Examples.

<Example 1>

Aluminum oxide powder (grade AA-07, specific surface area: 2.2 m$^2$/g, D50: 0.88 $\mu$m, manufactured by Sumitomo Chemical Co., Ltd.), magnesium carbonate powder, manganese carbonate powder, and strontium carbonate powder were used as raw materials of the phosphor, and the raw materials were weighed so that the composition of raw materials to be fed was Mn : Mg : Al : Sr = 0.3 : 0.7 : 22 : 2 in a molar ratio, and dry-mixed for 3 minutes. Next, the mixed raw materials were filled in an alumina container. Subsequently, the alumina container was set in an electric furnace, and a mixed gas of hydrogen : nitrogen = 5 : 95 was introduced into the furnace. The temperature was raised to 1,400°C, and the mixed raw materials were fired for 6 hours, and then allowed to cool. The fired product was recovered from the container to produce a phosphor of Example 1.

<Example 2>

Aluminum oxide powder (grade AA-05, specific surface area: 3.2 m$^2$/g, D50: 0.58 $\mu$m, manufactured by Sumitomo Chemical Co., Ltd.), magnesium carbonate powder, manganese carbonate powder, and strontium carbonate powder were used as raw materials of the phosphor, and the raw materials were weighed so that the composition of raw materials to be fed was Mn : Mg : Al : Sr = 0.3 : 0.7 : 22 : 2 in a molar ratio, and dry-mixed for 3 minutes. Next, the mixed raw materials were filled in an alumina container. Subsequently, the alumina container was set in an electric furnace, and a mixed gas of hydrogen : nitrogen = 10 : 90 was introduced into the furnace. The temperature was raised to 1,550°C, and the mixed raw materials were fired for 6 hours, and then allowed to cool. The fired product was recovered from the container to produce a phosphor of Example 2.

<Example 3>

A phosphor of Example 3 was produced in the same manner as in Example 2 except that aluminum oxide powder (grade A-210, specific surface area: 0.5 m$^2$/g, D50: 95 $\mu$m, manufactured by Sumitomo Chemical Co., Ltd.) was used instead of the aluminum oxide powder (grade AA-05).

<Example 4>

A phosphor of Example 4 was produced in the same manner as in Example 2 except that aluminum oxide powder (grade AA-10, specific surface area: 0.26 m$^2$/g, D50: 11.4 $\mu$m, manufactured by Sumitomo Chemical Co., Ltd.) was used instead of the aluminum oxide powder (grade AA-05).

<Example 5>

A phosphor of Example 5 was produced in the same manner as in Example 2 except that aluminum oxide powder (grade AA-18, specific surface area: 0.1 m$^2$/g, D50: 20.3 $\mu$m, manufactured by Sumitomo Chemical Co., Ltd.) was used instead of the aluminum oxide powder (grade AA-05).

<Comparative Example>

A phosphor of Comparative Example was produced in the same manner as in Example 1 except that aluminum oxide powder (grade AKP3000, specific surface area: 4.4 m$^2$/g, D50: 0.67 $\mu$m, manufactured by Sumitomo Chemical Co., Ltd.) was used instead of the aluminum oxide powder (grade AA-05), and barium fluoride as a flux was mixed so as to be 5 wt% with respect to the total amount of the raw materials of the phosphor.

<Various measurements and evaluations>

The following items were measured for the phosphors produced in Examples and Comparative Examples.

(a) Crystal structure and full width at half maximum for XRD peak

Powder X-ray diffraction using $CuK_\alpha$ rays was performed with an X-ray diffractometer ("X'Pert Pro" (trade name) manufactured by PANalytical). The obtained X-ray diffraction pattern showed a crystal structure of ICSD #82105 having a hexagonal structure and having a peak of the 100 plane at a position of $2\theta = 15$ to $25°$ and a peak of the 001 plane at a position of $2\theta = 5$ to $15°$ in all the samples.

(b) Specific surface area

For the phosphors of Examples 1, 2, 3, and 4 and Comparative Example 1, the specific surface area by the BET method was measured with a full automatic BET specific surface area analyzer ("MacsorbHM-1208" (trade name) manufactured by Mountech Co., Ltd.).

(c) Emission intensity of emission peak

The emission spectrum was measured with an absolute PL quantum yield spectrometer (trade name C9920-02, manufactured by Hamamatsu Photonics K.K., excitation light: 450 nm, room temperature, in the air, 150 mg), and the emission intensity of the emission peak were measured. When emission at 470 to 800 nm was measured, it was confirmed that all the phosphors were green light-emitting phosphors showing a maximum emission peak in a range of 510 nm to 550 nm. A method for evaluating the emission intensity is described below.
The area of the emission peak was determined from the measured spectrum, and converted into a percentage with the emission peak area of Comparative Example 1 as 100% to calculate the relative emission intensity.

(d) Selectivity of green light emission to red light emission

The emission spectrum was measured with a spectrofluorometer ("FP-6500" (trade name) manufactured by JASCO Corporation). In the measurement, an emission spectrum at an excitation wavelength of 450 nm was measured using a solid sample holder attached to the photometer. The emission intensity of green light emission was defined as a value of the emission intensity of the emission peak with the strongest emission in a range of 485 to 627 nm, and the emission intensity of red light emission was defined as a value of the emission intensity of the emission peak with the strongest emission in a range of 650 to 733 nm. The evaluation of the selectivity of the green light emission to the red light emission was calculated according to the following equation.

```
Selectivity of green light emission to red light

emission = emission peak intensity of green light

emission/emission peak intensity of red light emission
```

The characteristic values and evaluation results of the phosphors of Examples and Comparative Examples are summarized in Table 1.

[Table 1]

| Composition*: $Sr_2Mg_{0.7}Mn_{0.3}Al_{22}O_{36}$ | Example 1 | Example 2 | Example 3 | Example 4 | Example 5 | Comparative Example |
|---|---|---|---|---|---|---|
| Selectivity of green light emission to red light emission | 111 | 129 | 197 | 223 | 230 | 92.4 |
| Specific surface area ($m^2/g$) | 2.28 | 2.10 | 0.61 | 0.24 | 0.16 | 2.7 |
| Relative emission intensity | 117% | 107% | 183% | 196% | 215% | 100% |
| *Composition of raw materials to be fed. | | | | | | |

Table 1 shows that $Sr_2Mg_{0.7}Mn_{0.3}Al_{22}O_{36}$ phosphors having a specific surface area of 0.24 to 2.28 $m^2/g$ has enhanced selectivity of green light emission to red light emission.

<Reference Example 1>

The phosphors described in Examples 1 to 5 are combined with a resin, the resulting composite material is sealed in a glass tube or the like, and then the glass tube is disposed between a blue light-emitting diode as a light source and a light guiding plate, thereby producing a backlight capable of converting blue light of the blue light-emitting diode into green light or red light.

<Reference Example 2>

A resin composition can be obtained by combining the phosphors described in Examples 1 to 5 with a resin to form a sheet. A film prepared by sandwiching and sealing the sheet of the resin composition with two barrier films is disposed on a light guiding plate, thereby producing a backlight capable of converting, blue light emitted from a blue light-emitting diode disposed on an end surface (side surface) of the light guiding plate to the sheet through the light guiding plate, into green light or red light.

<Reference Example 3>

The phosphors described in Examples 1 to 5 are combined with a resin, and the resulting composite material is disposed in the vicinity of a light-emitting part of a blue light-emitting diode, thereby producing a backlight capable of converting emitted blue light into green light or red light.

<Reference Example 4>

A wavelength conversion material can be obtained by mixing the phosphors described in Examples 1 to 5 with a resist and then removing the solvent from the mixture. The obtained wavelength conversion material is disposed between a blue light-emitting diode as a light source and a light guiding plate or at a rear stage of an organic light-emitting diode (OLED) as a light source, thereby producing a backlight capable of converting blue light of the light source into green light or red light.

<Reference Example 5>

The phosphors described in Examples 1 to 5 are mixed with conductive particles such as ZnS particles to form a film, an n-type transport layer is laminated on one side of the film, and a p-type transport layer is laminated on the other side of the film, to thereby obtain an LED. When a current flows through the LED, holes of the p-type semiconductor and electrons of the n-type semiconductor cancel the charge in the perovskite compound of the junction surface, so that light can be emitted.

<Reference Example 6>

A titanium oxide dense layer is laminated on the surface of a fluorine-doped tin oxide (FTO) substrate, a porous aluminum oxide layer is laminated thereon, each of the phosphors described in Examples 1 to 5 is laminated thereon, after removing the solvent, a hole transport layer made of 2,2',7,7'-tetrakis-(N,N'-di-p-methoxyphenylamine)-9,9'-spirobifluorene (Spiro-OMeTAD) or the like is laminated thereon, and a silver (Ag) layer is laminated thereon to produce a solar cell.

<Reference Example 7>

A composition of the present embodiment can be obtained by combining the phosphors described in Examples 1 to 5 with a resin and molding the resulting composite material. This composition is disposed at a rear stage of a blue light-emitting diode, thereby producing laser diode illumination that converts, blue light emitted from the blue light-emitting diode to the composition, into green light or red light and emits white light.

<Reference Example 8>

The composition of the present embodiment can be obtained by combining the phosphors described in Examples 1 to 5 with a resin and molding the resulting composite material. The obtained composition is used for a photoelectric conversion layer, thereby producing a photoelectric conversion element (photodetection element) material used for and contained in a detection part that detects light. The photoelectric conversion element material is used for an image detection part (image sensor) for solid-state imaging devices such as X-ray imaging devices and CMOS image sensors, a detection part that detects a predetermined feature of a part of a living body, such as a fingerprint detection part, a face detection part, a vein detection part, and an iris detection part, and an optical biosensor such as a pulse oximeter.

<Reference Example 9>

The composition of the present embodiment can be obtained by combining the phosphors described in Examples 1 to 5 with a resin and molding the resulting composite material. The obtained composition can be used as a film for improving the light conversion efficiency of a solar cell. The form of the conversion efficiency improvement sheet is not particularly limited, and the sheet is used in the form of applying the composition to a substrate. The substrate is not particularly limited as long as it is a substrate having high transparency. For example, a PET film, or a moth-eye film is desirable. The solar cell produced using the solar cell conversion efficiency improvement sheet is not particularly limited, and the conversion efficiency improvement sheet has a conversion function from a wavelength range where the sensitivity of the solar cell is low to a wavelength range where the sensitivity is high.

<Reference Example 10>

The composition of the present embodiment can be obtained by combining the phosphors described in Examples 1 to 5 with a resin and molding the resulting composite material. The obtained composition can be used as a light source for single photon generation such as a quantum computer, quantum teleportation, and quantum cryptographic communication.

**Claims**

1. A phosphor having an elemental composition represented by the following composition formula:

$$Sr_yMg_{(1-x)}M_xAl_zO_{(1+y+1.5z)} \qquad (1)$$

in the formula (1), M represents at least one metal element selected from the group consisting of manganese, cerium, praseodymium, neodymium, samarium, europium, gadolinium, terbium, dysprosium, thulium, and ytterbium,

x represents a value of $0.01 \leq x \leq 0.8$,
y represents a value of $1 \leq y \leq 2$, and
z represents a value of $10 \leq z \leq 22$,
wherein the phosphor has a specific surface area of less than 2.7 $m^2/g$.

2. The phosphor according to claim 1, wherein y is 2, and z is 22.

3. The phosphor according to claim 1 or 2, wherein M is manganese.

4. A film comprising the phosphor according to any one of claims 1 to 3.

5. A light-emitting element comprising the phosphor according to any one of claims 1 to 3.

6. A light-emitting device comprising the light-emitting element according to claim 5.

7. A display comprising the light-emitting element according to claim 5.

8. A phosphor wheel comprising the phosphor according to any one of claims 1 to 3.

9. A projector comprising the phosphor wheel according to claim 8.

10. A method for producing the phosphor according to any one of claims 1 to 3, comprising firing a raw material mixture containing a Sr compound as a raw material of a Sr element, a Mg compound as a raw material of a Mg element, an M compound as a raw material of an M element, and an Al compound as a raw material of an Al element.

## INTERNATIONAL SEARCH REPORT

International application No.

**PCT/JP2021/039674**

### A. CLASSIFICATION OF SUBJECT MATTER

*C09K 11/08*(2006.01)i; *C09K 11/64*(2006.01)i; *G03B 21/00*(2006.01)i; *G03B 21/14*(2006.01)i; *H01L 33/50*(2010.01)i; *H01L 27/32*(2006.01)i; *G02B 5/20*(2006.01)i; *H05B 33/12*(2006.01)i; *H01L 51/50*(2006.01)i
FI: C09K11/64; C09K11/08 B; H05B33/14 A; H05B33/12 E; H01L27/32; G02B5/20; H01L33/50; G03B21/00 D; G03B21/14 A

According to International Patent Classification (IPC) or to both national classification and IPC

### B. FIELDS SEARCHED

Minimum documentation searched (classification system followed by classification symbols)

C09K11/08; C09K11/64; G03B21/00; G03B21/14; H01L33/50; G02B5/20; H01L27/32; H05B33/12; H01L51/50

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

CAplus/REGISTRY (STN)

### C. DOCUMENTS CONSIDERED TO BE RELEVANT

| Category* | Citation of document, with indication, where appropriate, of the relevant passages | Relevant to claim No. |
|---|---|---|
| A | ZHANG, Haiming et al. Ceramics International. 2016, 42, 13011-13017, doi: 10.1016/ j.ceramint.2016.05.076 <br> entire text | 1-10 |
| A | CN 101747893 B (IRICO GROUP CORPORATION) 16 January 2013 (2013-01-16) <br> example 3 | 1-10 |
| A | CN 108949168 A (CHINA UNIVERSITY OF GEOSCIENCES (WUHAN)) 07 December 2018 (2018-12-07) <br> example 2 | 1-10 |
| A | ZHU, Yingli et al. Advanced Optical Materials. 2019, 7, 1801419, doi: 10.1002/ adom.201801419 <br> entire text | 1-10 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **11 January 2022** | **18 January 2022** |

| Name and mailing address of the ISA/JP | Authorized officer |
|---|---|
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (January 2015)

**INTERNATIONAL SEARCH REPORT**
Information on patent family members

International application No.

**PCT/JP2021/039674**

| Patent document<br>cited in search report | Publication date<br>(day/month/year) | Patent family member(s) | Publication date<br>(day/month/year) |
|---|---|---|---|
| CN 101747893 B | 16 January 2013 | (Family: none) | |
| CN 108949168 A | 07 December 2018 | (Family: none) | |

Form PCT/ISA/210 (patent family annex) (January 2015)

**REFERENCES CITED IN THE DESCRIPTION**

**Non-patent literature cited in the description**

- **YINGLI ZHU et al.** NarrowBand Green-Emitting Sr2MgAl22036:Mn2+ Phosphors with Superior Thermal Stability and Wide Color Gamut for Backlighting Display Applications. *Adv. Optical Mater.,* 2019, vol. 7 (1801419), 1-9